# EUROPEAN PATENT APPLICATION

(11) **EP 4 660 172 A1**
(43) Date of publication of application: **10.12.2025**
(21) Application number: 23920007.4
(22) Date of filing: 25.12.2023
(51) Int. Cl.: C04B 41/87, C04B 35/582, C04B 35/5835, H01L 21/683

(54) **WAFER SUPPORT**

(30) Priority: 03.02.2023 JP 2023015682
(71) Applicant: Ferrotec Corporation, Tokyo 103-0027 (JP)
(72) Inventor: YAMAGISHI, Wataru, Hakusan-City Ishikawa 924-0833 (JP); MORI, Kazumasa, Hakusan-City Ishikawa 924-0833 (JP); KOUNO, Hitoshi, Hakusan-City Ishikawa 924-0833 (JP); ETO, Shunichi, Hakusan-City Ishikawa 924-0833 (JP); SHIBASE, Atsushi, Hakusan-City Ishikawa 924-0833 (JP)
(74) Representative: Isarpatent
(86) International application number: PCT/JP2023/046509
(87) International publication number: WO 2024/161872

(57) **Abstract**

A wafer support (30) includes a base material (14) made of a machinable ceramic including boron nitride; a first layer covering the base material; and a conductive member (18, 20) placed at least partially inside the base material. The first layer is made of an aluminum nitride-based ceramic sintered body, and the proportion of boron nitride included in the base material (14) is higher than the proportion of boron nitride included in the first layer.

## Description

### Technical Field

The present invention relates to a support that supports a wafer.

### Background Art

Many of ceramic materials used for conventional electrostatic chucks and the like are fine ceramics difficult to process, such as silicon nitride and aluminum nitride, and complicated processing of them has been difficult from the viewpoint of cutting speed and chipping (defect). Therefore, a wafer support has been devised in which a machinable ceramic excellent in processability is used as a base material (see Patent Literature 1).

### Citation List

### Patent Literature

Patent Literature 1: JP 2020-155571 A

### Summary of Invention

### Technical Problem

If the above-described wafer support is exposed to a corrosive gas or a plasma atmosphere in a semiconductor manufacturing process, particles are easily generated from the surface. Adhesion of the particles to the wafer causes a fault in the subsequent semiconductor manufacturing process. Thus, it is an idea to cover a base material of a machinable ceramic with a film made of aluminum nitride, which is less corrodible by plasma.

If, however, corrosion originating from a minute defect such as a pinhole present in the aluminum nitride film has occurred and reached the machinable ceramic that is the base material, the machinable ceramic is significantly corroded, which produces particles and causes defective products.

The present invention has been made in view of such a circumstance, and an object of the present invention is to provide a novel wafer support excellent in corrosion resistance.

### Solution to problem

To solve the aforementioned problems, a wafer support of an aspect of the present invention includes: a base material made of a machinable ceramic including boron nitride; a first layer covering a surface of the base material; and a conductive member placed at least partially inside the base material. The first layer is made of an aluminum nitride-based ceramic sintered body, and a proportion of boron nitride included in the base material being higher than a proportion of boron nitride included in the first layer.

The machinable ceramic is easier to process than general fine ceramics, and has excellent thermal shock resistance. The machinable ceramic such as boron nitride, however, is not necessarily the most suitable material in terms of corrosion resistance. Therefore, according to this aspect, the wafer support can be processed after the base material is prepared even if a complicated shape has not been achieved when the base material is prepared, which enables manufacture of wafer supports having various shapes. Furthermore, according to this aspect, corrosion of the base material by a process gas or plasma can be reduced by the first layer.

The first layer may have a thickness of 0.3 to 3.0 mm. As a result, even if a minute defect such as a pinhole is present in the first layer, corrosion is less likely to reach the base material.

The first layer may include 90 to 100 mass% of aluminum nitride and 0 to 10 mass% of boron nitride. This improves the corrosion resistance of the first layer.

A second layer covering the first layer may further be included. The second layer may include at least one material selected from the group consisting of aluminum nitride, aluminum oxide, yttrium oxide, and magnesium oxide, and have a thickness of 1.0 to 20 µm. This further improves the corrosion resistance of the base material as compared with the case where only the first layer is used.

|Δ2-Δ1| ≤ 1.0 is satisfied where a thermal expansion coefficient of the base material is represented by Δ1 [1×10⁻⁶/°C] and a thermal expansion coefficient of the first layer is represented by Δ2 [1×10⁻⁶/°C]. This allows the base material and the first layer to be integrally formed by sintering.

The machinable ceramic may include 15 to 40 mass% of boron nitride, 0 to 40 mass% of zirconium oxide, 0 to 55 mass% of silicon nitride, 0 to 20 mass% of silicon carbide, and 0 to 75 mass% of aluminum nitride with respect to 100% of a total of ceramic components of boron nitride, zirconium oxide, silicon nitride, silicon carbide, and aluminum nitride. The machinable ceramic may further include 3 to 15 mass% of a sintering aid component with respect to 100 mass% of the total of the ceramic components.

The conductive member may include a metal material selected from the group consisting of molybdenum, tungsten, tantalum, and alloys containing molybdenum, tungsten, and tantalum.

Note that any combination of the above constituent elements and a modification of the expression of the present invention in methods, devices, systems, and the like are also effective as aspects of the present invention. Furthermore, an appropriate combination of the above-described elements can also be included in the scope of the invention for which patent protection is sought by the present patent application.

### Advantageous Effects of Invention

According to the present invention, a novel wafer support excellent in corrosion resistance can be realized.

### Brief Description of Drawings

FIG. 1 is a schematic sectional view of a wafer support according to a reference example.
FIG. 2 is a schematic diagram for explaining corrosion occurring when a defect is present in a protective layer.
FIG. 3 shows a photograph of a section of a wafer support having a defect in an AlN film taken with a scanning electron microscope (SEM).
FIG. 4 is a schematic sectional view of a wafer support according to an embodiment.
In FIG 5, (a) to (e) illustrate an example of a method of producing the wafer support according to the embodiment.
FIG. 6A shows a photograph of a section of a protective layer of an aluminum nitride sintered body according to Example 1 taken with a scanning electron microscope (SEM), FIG. 6B shows a photograph of a section of a protective layer of an aluminum nitride sintered body according to Example 3 taken with the scanning electron microscope, and FIG. 6C shows a photograph of a section of the aluminum nitride film according to the reference example taken with the scanning electron microscope.

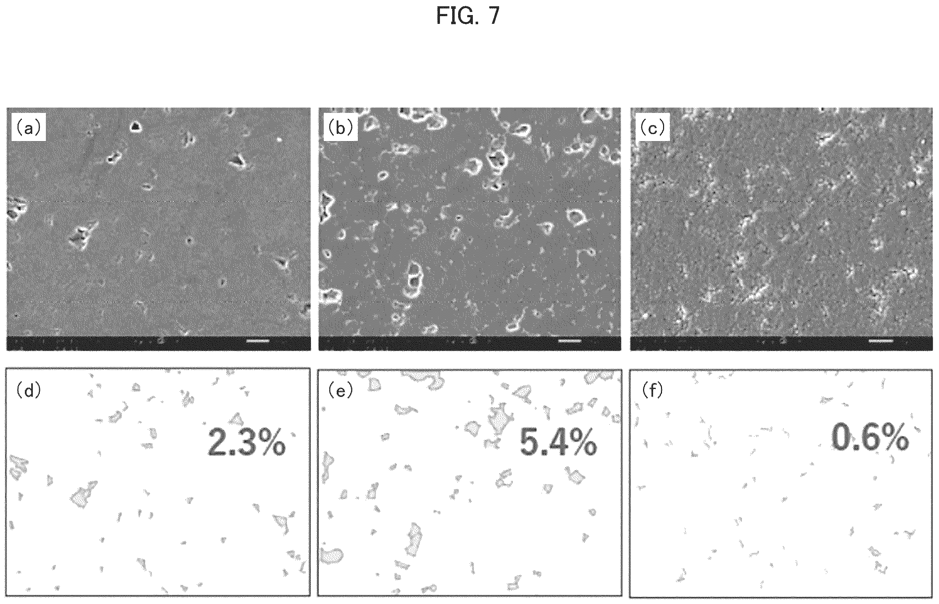

In FIG. 7, (a) shows a photograph of a surface of the protective layer of the aluminum nitride sintered body according to Example 1 taken with a scanning electron microscope (SEM), (b) shows a photograph of a surface of the protective layer of the aluminum nitride sintered body according to Example 3 taken with the scanning electron microscope, (c) shows a photograph of a surface of the aluminum nitride film according to the reference example taken with the scanning electron microscope, (d) shows an image obtained by converting the photograph of (a) by image analysis software, (e) shows an image obtained by converting the photograph of (b) by the image analysis software, and (f) shows an image obtained by converting the photograph of (c) by the image analysis software.
In FIG. 8, (a) to (c) are schematic diagrams for explaining a plasma exposure test.

### Description of Embodiments

Some embodiments of the present invention will now be described in detail with reference to the drawings. In description of the drawings, the same element is denoted by the same reference sign, and redundant description will be omitted as appropriate.

### (Wafer Support)

First, a schematic structure of a wafer support according to a reference example will be described. A wafer support is to be capable of supporting a semiconductor substrate such as a silicon wafer, and may include an adsorption mechanism or a heating mechanism. For example, the wafer support may simply be a susceptor on which a wafer is mounted. Furthermore, the wafer support may be an electrostatic chuck that generates an adsorption force on a mounted wafer or a heater that heats the wafer. The object supported by the wafer support is mainly a wafer, but another member or component may be supported.

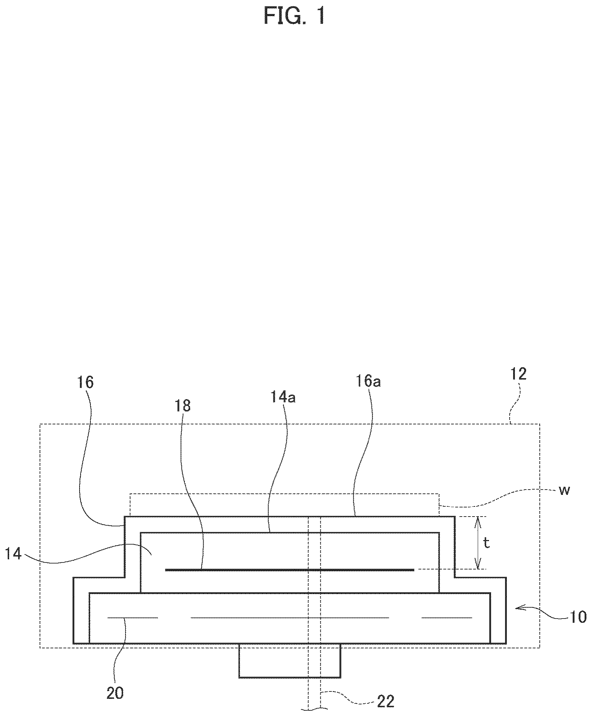

In the reference example, a case where the wafer support is an electrostatic chuck with a heater will be described as an example. FIG. 1 is a schematic sectional view of a wafer support according to the reference example.

A wafer support 10 according to the reference example is used for supporting a wafer W in a chamber 12 in an apparatus for semiconductor manufacturing such as plasma CVD. The wafer support 10 includes a base material 14 including a machinable ceramic, a protective layer 16 covering a surface 14a of the base material 14, and conductive members 18 and 20 placed at least partially inside the base material 14. The wafer W is mounted on a surface as a mounting surface 16a of the protective layer 16.

The conductive member 18 functions as an electrostatic chuck electrode through which a current flows that generates an adsorption force for fixing of the wafer W to the mounting surface 16a. The conductive member 20 functions as a resistance heating body (heater) for heating of the wafer W to a predetermined process temperature. In the wafer support 10 according to the present embodiment, the conductive members 18 and 20 are embedded in the base material 14 that is a sintered body. Therefore, the conductive members 18 and 20 are to be disposed inside a raw material powder at the stage of firing, and are preferably a high melting point metal that does not melt at the firing temperature. For example, the material of the conductive member is preferably a high melting point metal such as molybdenum, tungsten, or tantalum, or an alloy containing two or more kinds thereof.

In the wafer support 10, a gas inlet 22 may be formed that passes through the inside of the base material 14 from the mounting surface 16a exposed to the chamber side to a gas supply source (not illustrated) on the outside. The gas inlet 22 supplies a gas that cools the wafer W adsorbed on the mounting surface 16a from the back surface side.

### (Machinable Ceramic)

As a result of intensive studies to find a material suitable for the wafer support, the present inventors have found that a sintered body is preferable that includes a so-called machinable ceramic good in processability (having a free-cutting property).

Machinable ceramics are easier to machine than general fine ceramics such as aluminum oxide, silicon nitride, aluminum nitride, and silicon carbide. That is, in a machinable ceramic, defect called chipping, which is a problem in processing of the ceramic, is less likely to occur, and complicated processing is possible. Furthermore, the amount of a machinable ceramic ground at the time of processing (processing rate) is several times to several hundred times the amount of a fine ceramic ground at the time of processing, and thus efficient processing can be performed.

A machinable ceramic is a composite material in which a plurality of raw material compounds as ceramic components are mixed, and the volume resistivity can be adjusted by, for example, the blending ratio of silicon carbide. As a result, it is possible to cope with both the adsorption mechanisms of an electrostatic chuck of the Coulomb type and the Johnsen-Rahbek type. In the case of a heater, the machinable ceramic can be used as an insulator without adding silicon carbide. The machinable ceramic does not need to have a uniform composition as a whole, and the composition may be varied so that the function of each portion is optimized in the portion accommodating the conductive member 18 in the vicinity of the mounting surface 16a on which the wafer W is mounted and the portion accommodating the conductive member 20.

Furthermore, boron nitride as one of the main components has more excellent thermal shock resistance than typically used aluminum oxide, silicon nitride, aluminum nitride, and silicon carbide, and can prevent damage due to fracture when included in a wafer support as a product.

The machinable ceramic according to the reference example and an embodiment to be described later is a sintered body that includes at least two materials selected from the group consisting of boron nitride, zirconium oxide, silicon nitride, silicon carbide, and aluminum nitride and essentially includes boron nitride. Boron nitride is also excellent in machinability, and using the machinable ceramic including boron nitride as an essential component can increase the processing rate. In the case of a wafer support in which a conductive member as a different material is placed inside a base material, an internal stress is generated due to a temperature change according to a difference in physical properties between the base material and the conductive member. Alternatively, thermal stress is generated due to a temperature difference between the outer peripheral portion and the central portion of the wafer support. However, the base material is less likely to fracture because boron nitride has excellent thermal shock resistance.

The machinable ceramic according to the reference example is to include 10 to 80 mass% of boron nitride, 0 to 80 mass% of silicon nitride, 0 to 80 mass% of zirconium oxide, and 0 to 40 mass% of silicon carbide with respect to 100 mass% of a total of ceramic components of boron nitride, zirconium oxide, silicon nitride, and silicon carbide.

The machinable ceramic according to the reference example and the embodiment to be described later includes a sintering aid component. The sintering aid can be selected from those used for sintering silicon nitride and boron nitride. Preferred sintering aids are one or more obtained from aluminum oxide (alumina), magnesium oxide (magnesia), yttrium oxide (yttria), and oxides of lanthanoid metals. More preferred sintering aids are a mixture of alumina and yttria, the above-described mixture to which magnesia is further added, a mixture of yttria and magnesia, and the like.

The amount of the sintering aid component blended is desirably in the range of 1 to 25 mass%, preferably 3 to 15 mass% or more preferably 5 to 10 mass% with respect to 100 mass% of the total of the ceramic components (not including the sintering aid component). If the amount of the sintering aid component blended is 1 mass% or more, preferably 3 mass% or more, the sintered body is easily densified, and lack of density and deterioration of a mechanical characteristic in the sintered body can be suppressed. Meanwhile, if the amount of the sintering aid component blended is 25 mass% or less, the grain boundary phase having low strength is reduced, so that deterioration of the mechanical strength and deterioration of the processability due to an increase in the grain boundary phase can be suppressed.

Boron nitride is excellent in machinability but poor in strength characteristics. Therefore, coarse boron nitride present in the sintered body becomes fracture origin to cause defect and fracture at the time of processing. For preventing formation of such coarse boron nitride particles, pulverizing a raw material powder is effective. A main raw material powder, particularly a raw material powder of boron nitride having an average particle size of less than 2 µm is desirably used. Boron nitride has a phase such as a hexagonal (h-BN) low-pressure phase or a cubic (c-BN) highpressure phase, and hexagonal boron nitride is preferable from the viewpoint of a free-cutting property. From the viewpoint of processability, a larger amount of boron nitride and a smaller amount of silicon nitride (and zirconium oxide) are more preferable. Furthermore, the larger the amount of boron nitride is and the smaller the amount of silicon nitride (and zirconium oxide) is, the lower the mechanical strength and the Young's modulus are.

Examples of the machinable ceramic include a BN-containing silicon nitride-based ceramic ("Photoveel II" and "Photoveel II-k70", manufactured by Ferrotec Material Technologies Corporation). Photoveel II-k70 has a composition including 38.5 mass% of boron nitride, 54.1 mass% of silicon nitride, 5.5 mass% of yttria, and 1.9 mass% of magnesia. This BN-containing silicon nitride-based ceramic has a bending strength of 600 MPa or less, a Young's modulus of 250 GPa or less, and a Vickers hardness of 5 GPa or less. In using a machinable ceramic having such characteristics, the amount of the ceramic ground per unit time at the time of processing (processing rate) is large, and even a wafer support having a complicated shape can be efficiently produced. Furthermore, the base material is prepared as a block having a simple shape and then cut into a desired shape, and thus a complicated wafer support can be manufactured with one component.

### (Method of Manufacturing Sintered Body)

First, main raw material powders as ceramic components including boron nitride, zirconium oxide, silicon nitride, silicon carbide, aluminum nitride, and the like and 1 to 25 mass% of a sintering aid powder with respect to 100 mass% of the total of the ceramic components are mixed in accordance with predetermined blending amounts to prepare a raw material powder. This mixing can be performed with, for example, a wet ball mill or the like.

Next, the raw material powder or the molded body, or both the raw material powder and the molded body are molded under high temperature and pressure, and fired to prepare a sintered body. A part of the raw material powder or the molded body may be replaced with a sintered body. In order to provide a resistance heating body for a heater and an electrode of an electrostatic chuck inside the sintered body, a member or a material to be a conductor after firing (such as a metal plate, a metal foil, a conductive paste, a coil, or a mesh) is to be disposed (embedded) at a predetermined position at the time of filling a hot press apparatus with the raw material powder, the molded body, or the sintered body. The shape of the conductor is not particularly limited. This firing can be performed using, for example, a hot press apparatus. The hot pressing is performed in a non-oxidizing (inert) atmosphere such as a nitrogen or argon atmosphere, or may be performed in pressurized nitrogen. The hot pressing temperature is, for example, in the range of 1300 to 1950°C. If the temperature is too low, sintering becomes insufficient, and if the temperature is too high, thermal decomposition of the main raw material occurs. The appropriate pressure is in the range of 20 to 50 MPa. The duration of the hot pressing depends on the temperature and dimensions, and is usually about 1 to 4 hours. The high temperature pressure sintering can also be performed by hot isostatic pressing (HIP). Sintering conditions in this case can also be appropriately set by those skilled in the art.

Then, the sintered body is processed into a desired shape to manufacture a wafer support. The machinable ceramic according to the reference example or the embodiment has high strength and high machinability (a free-cutting property), so that complicated fine processing can be performed in an industrially feasible time. Various conditions in manufacturing the sintered body are to be selected so that the machinable ceramic has an average crystal grain size of 0.5 µm or less in consideration of corrosion resistance to plasma described below. As a result, even if a part of the polycrystal is separated as particles due to corrosion in a plasma atmosphere, the particles themselves are small, and thus faults in the semiconductor manufacturing process can be reduced. The average crystal grain size of the machinable ceramic is more preferably 0.1 µm or less.

As described above, the machinable ceramic used in the base material 14 according to the reference example is easier to process than general fine ceramics. Therefore, according to this aspect, wafer supports having various shapes can be manufactured even if a complicated shape is not realized at the stage of preparing the base material 14, because the machinable ceramic can be processed after the base material is prepared.

Meanwhile, the wafer support 10 is exposed to a corrosive gas or a plasma atmosphere in a semiconductor manufacturing process according to the use of the wafer support 10. Examples of the corrosive plasma include fluorine-based gases such as CF₄, C₄F₈, SF₈, NF₃, and CHF₃, and in addition, a gas such as Ar, O₂, or CO₂ may be mixed. The silicon component has high reactivity with fluorine-based plasma, and therefore a base material including silicon has low resistance to such plasma. Boron nitride has high reactivity with O₂ plasma.

As described above, the machinable ceramic according to the reference example may include silicon nitride, silicon carbide, and boron nitride as main components, and the inventors of the present application have conceived of a possibility that the machinable ceramic including silicon and boron nitride has low corrosion resistance in a corrosive plasma atmosphere. Then, in order to improve the corrosion resistance of the wafer support to plasma or a process gas, the protective layer 16 is provided on the surface of the base material 14 of the wafer support 10 according to the present embodiment.

### (Protective Layer)

The protective layer 16 according to the reference example includes a material that is less corrodible by plasma than the base material 14. As a result, corrosion of the base material 14 due to plasma can be reduced by the protective layer 16. Furthermore, even in a case where the base material 14 includes a material that is likely to separate, separation can be reduced by the protective layer 16. The protective layer 16 according to the present embodiment includes at least one material selected from the group consisting of aluminum nitride, aluminum oxide, yttrium oxide, magnesium oxide, yttrium aluminum garnet (YAG: Y₃Al₅O₁₂), and yttrium aluminum monoclinic (YAM: Y₄Al₂O₉). Aluminum nitride is particularly excellent in thermal shock resistance, and therefore is a suitable material in a process in which a high thermal shock is applied to an electrostatic chuck.

As illustrated in FIG. 1, the thickness between the mounting surface 16a, which is the surface of the protective layer 16, and the conductive member 18 is the thickness t of the dielectric layer. Therefore, if the film thickness of the protective layer 16 is too large, the thickness t of the dielectric layer is too large to obtain a sufficient adsorption force. If the thickness t is too large, a crack is likely to occur in the protective layer 16 when a high thermal shock is applied. Meanwhile, if the thickness t of the protective layer 16 is too small, sufficient corrosion resistance to plasma cannot be obtained. Therefore, the protective layer 16 according to the reference example has a thickness in the range of 1 to 30 µm. As a result, both a desired adsorption force and corrosion resistance to plasma can be achieved. If the thickness of the protective layer 16 is preferably 2 µm or more and more preferably 5 µm or more, further good corrosion resistance to plasma can be obtained. If the thickness of the protective layer 16 is preferably 20 µm or less and more preferably 10 µm or less, a further sufficient adsorption force can be obtained.

### (Method of Forming Protective Layer)

The protective layer is formed with, for example, a method such as CVD, PVD (sputtering or ion plating), or aerosol deposition. These methods are excellent in film thickness control, and therefore a film having a thickness in the range of 1 to 30 µm can be formed with high accuracy like the above-described protective layer.

In sputtering, a substrate and a target (material to be a film) are made opposite to each other, a negative high voltage is applied to the target to cause discharge in an Ar gas atmosphere of about 10⁻¹ to several Pa, and Ar ions are collided with the target. When Ar ions are collided with the target, a sputtering phenomenon occurs in which atoms are ejected from the target. The ejected atoms are deposited on the base material to form a protective layer.

For forming the protective layer 16 according to the reference example, a reactive sputtering method is suitable. It is known that in the case of using a compound such as aluminum oxide or aluminum nitride as a target, the sputtering rate is remarkably reduced to reduce the coating rate extremely and a film is formed that has a composition deviated from that of the target because each element has a different sputtering rate. Therefore, in a case where the constituent material of the protective layer according to the reference example is aluminum nitride, a reactive sputtering method is suitable in which a single metal aluminum target is used and reacted with N₂ as a reactive gas.

Ion plating, which is another method of forming a protective layer, is a method in which a substrate and an evaporation source (material to be a film) are made opposite to each other and a raw material of a film is dissolved and evaporated from the evaporation source in a vacuum of about 10⁻² to 10⁻⁴ Pa and thus deposited on the substrate. Films of various materials depending on the kind of the material to be evaporated can be prepared by introduction of a reaction gas. In coating technology based on vacuum deposition, general methods using ions are called ion plating. Specifically, ion plating includes various methods such as radio-frequency ion plating, reactive ion plating, and ion-assisted deposition, and any method can be used. In a case where the constituent material of the protective layer according to the reference example is yttrium oxide, a film can be formed in a plasma atmosphere by using metal yttrium as a vapor deposition source and introducing O₂ into the reaction gas. In the case of ion-assisted deposition, a protective layer including yttrium oxide as a constituent material can be formed by using yttrium oxide as a vapor deposition source and O₂ ions as assist ions. Also in the case of a protective layer including magnesium oxide or aluminum oxide as a constituent material, a film can be formed by radio-frequency ion plating, reactive ion plating, or ion-assisted deposition.

In the case of a method of forming a film using ions, such as sputtering or ion plating described above, the surface can be cleaned with Ar ions (a surface deposit or an oxide film can be removed by ion impact) before film formation, so that a film having high adhesion can be obtained. N₂ ions and H₂ ions are particularly effective for cleaning an organic substance (a step generally called ion bombardment). The bombardment step can remove ultrafine particles (those that cannot be removed by ultrasonic cleaning or the like) on the surface of the machinable ceramic as the base material, and thus in the base material including the protective film, generation of particles at an initial stage can be reduced as compared with the base material including no protective film. In these methods, the purity of aluminum nitride can also be higher than in a bulk ceramic produced by baking and solidifying a powder, and therefore the possibility of wafer contamination is reduced to contribute to reduction of faults.

If the base material including the machinable ceramic has a surface roughness in a predetermined range (for example, an arithmetic mean roughness Ra in the range of 0.02 µm ≤ Ra ≤ 0.2 µm), the electrostatic chuck using the base material comes into point contact with the wafer, and thus is less likely to rub against the wafer during dechucking. Meanwhile, the cleavage property of boron nitride is likely to cause separation of particles (crack) by a physical force, and therefore particles are likely to be generated as they are. However, if the surface of the base material 14 is coated with the protective layer 16 such as aluminum nitride described above, separation of particles is reduced, and generation of particles can be reduced. In addition, the protective layer 16 prepared with the film forming method according to the reference example follows the surface roughness of the base material 14, and has a surface having an arithmetic mean roughness Ra in the range of 0.02 µm ≤ Ra ≤ 0.2 µm. That is, the protective layer 16 having corrosion resistance to plasma is included, and in addition, the protective layer 16 itself can be in point contact with the wafer, and therefore the wafer support 10 according to the reference example is extremely excellent in reducing particles.

In the case of a multilayer member in which each layer includes a hard material (combination of materials having a high Young's modulus), all of the layers are less likely to deform, and thus a crack easily occurs due to a thermal stress or the like. However, the stress can be absorbed (relaxed) by using the base material 14 including boron nitride as a main component as in the wafer support 10 according to the reference example. Furthermore, since the machinable ceramic according to the reference example is a composite material, the thermal expansion coefficient of the base material 14 can be matched with the thermal expansion coefficient of the protective layer 16. As a result, the thermal stress due to difference in the thermal expansion coefficient of each layer can be reduced, and occurrence of a crack, that is, generation of particles is suppressed.

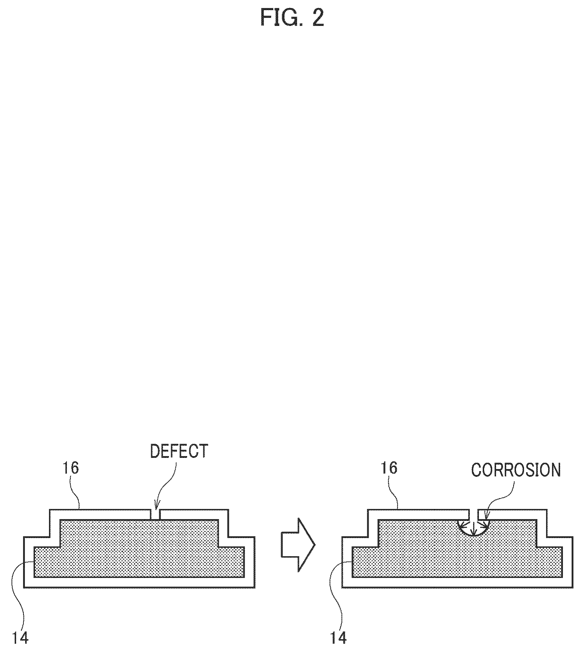

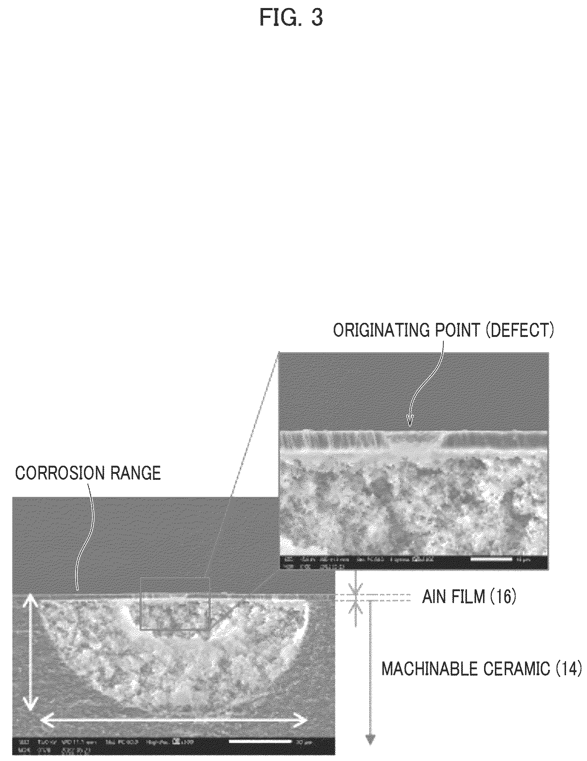

The wafer support according to the reference example described above has the excellent thermal shock resistance of the machinable ceramic and is also improved in corrosion resistance to plasma and a process gas by the protective layer 16. The present inventors, however, have conceived that, if there is a minute defect such as a pinhole (small hole) present in an AlN film, which is the protective layer, the problems described below can occur. FIG. 2 is a schematic diagram for explaining corrosion occurring when a defect is present in the protective layer. FIG. 3 shows a photogram of a section of a wafer support having a defect in an AlN film taken with a scanning electron microscope (SEM).

As shown in FIGS. 2 and 3, in a case where corrosion originating from a defect has occurred and reached the machinable ceramic, which is the base material, the machinable ceramic is significantly corroded. As a result, particles are produced, which causes defective products. In addition, with common film forming technologies, it is very difficult to eliminate minute defects such as pinholes. Furthermore, if the whole AlN film is lost due to overall corrosion, the base material made of the machinable ceramic having a low corrosion resistance is exposed at the front surface, which results in generation of a large quantity of particles that not only cause defective products but also contaminate the apparatus. This results in increased equipment failure and downtime.

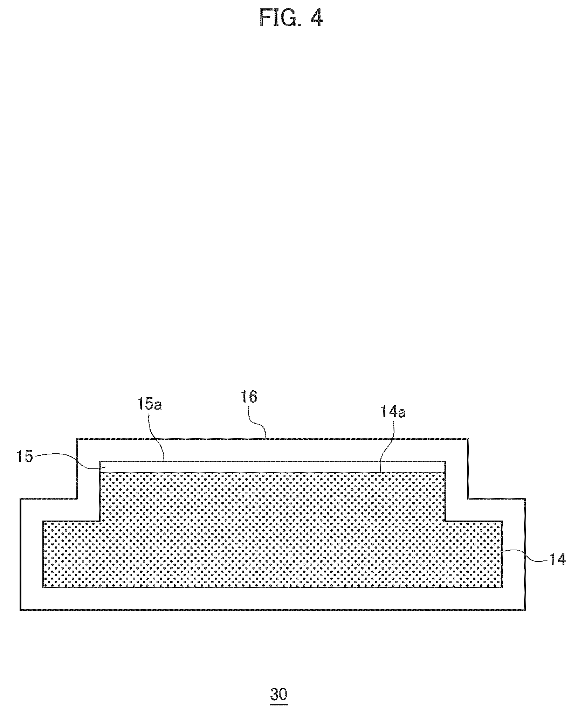

Therefore, in a wafer support according to the present embodiment, an aluminum nitride-based sintered body is provided between the protective layer 16 and the base material 14. FIG. 4 is a schematic sectional view of the wafer support according to the present embodiment. Note that components (the conductive members 18 and 20, gas inlet 22, etc.) that are similar to those of the wafer support 10 according to the reference example illustrated in FIG. 1 are omitted in FIG. 4.

The wafer support 30 according to the present embodiment includes a base material 14 made of a machinable ceramic containing boron nitride, a protective layer 15 covering a surface 14a of the base material 14, and conductive members 18 and 20 placed at least partially inside the base material 14. The protective layer 15 is an aluminum nitride-based ceramic sintered body. The proportion of boron nitride included in the base material 14 is higher than that of boron nitride included in the protective layer 15. Alternatively, an intermediate layer consisting mainly of a machinable ceramic may be provided between the protective layer 15 and the base material 14.

The machinable ceramic is easier to process than general fine ceramics, and has excellent thermal shock resistance. The wafer support 30 according to the present embodiment can therefore be processed after the base material 14 is prepared even if a complicated shape has not been achieved when the base material 14 is prepared, which enables manufacture of wafer supports having various shapes.

The machinable ceramic such as boron nitride, however, is not necessarily the most suitable material in terms of corrosion resistance. Therefore, the protective layer 15 made of an aluminum nitride-based ceramic sintered body having a high corrosion resistance is further provided on the base material 14. This makes the base material 14 less likely to be directly exposed to a corrosive atmosphere even if minute defects or wear of the protective layer 16 made of an aluminum nitride film occur, and thus reduces corrosion of the base material 14 by a process gas or plasma. As a result, the quantity of particles is reduced, occurrence of faults in the manufacturing process is reduced, and a semiconductor manufacturing apparatus is protected.

Note that the protective layer 15 may have a thickness in a range of 0.3 to 3.0 mm or more preferably 0.5 to 2.0 mm. As a result, even if a minute defect such as a pinhole is present in the protective layer 15, corrosion is less likely to reach the base material. If the protective layer is too thin (thinner than 0.3 mm, for example), it is difficult to produce the protective layer as a sintered body, and a minute defect, if any, easily forms a hole penetrating to the base material. In contrast, if the protective layer is too thick (thicker than 3.0 mm, for example), the effect of improving the thermal shock resistance by laying the protective layer 15 having an inclined structure over the base material 14 of a machinable ceramic is eliminated.

The protective layer 15 may include 70 to 100 mass% of aluminum nitride, 0 to 30 mass% of boron nitride, 80 to 100 mass% of aluminum nitride, and 0 to 20 mass% of boron nitride, or preferably 90 to 100 mass% of aluminum nitride and 0 to 10 mass% of boron nitride. This improves of the corrosion resistance of the protective layer 15. Note that, in terms of thermal shock resistance, the protective layer 15 preferably includes more boron nitride. The finer the particles of aluminum nitride and boron nitride included in the protective layer 15, the higher the corrosion resistance. The average particle sizes of aluminum nitride and boron nitride are preferably 5 µm or smaller, or more preferably 2 µm or smaller. Smaller particle sizes result in generation of smaller particles, which reduces faults in semiconductors produced by an apparatus including the wafer support.

The wafer support 30 according to the present embodiment further includes a protective layer 16 that covers the protective layer 15. The protective layer 16 according to the present embodiment includes at least one material selected from the group consisting of aluminum nitride, aluminum oxide, yttrium oxide, and magnesium oxide, and has a thickness of 1.0 to 20 µm. The thickness of the protective layer 16 is more preferably 1.0 to 10 mm. This further improves the corrosion resistance of the base material 14 as compared with the case where only the protective layer 15 is used. If the protective layer 15 is too thin, the corrosion resistance becomes low (the component life is shortened). If the protective layer 15 is too thick, cracks are likely to occur due to internal stress during film formation.

In addition, with a thin film of aluminum nitride like the protective layer 16 formed on the protective layer 15 that is a ceramic sintered body having a relatively larger thickness, even if the protective layer 16 is corroded and the protective layer 15 of a ceramic sintered body thereunder is exposed, the protective layer 16 can be made again so that the wafer support can be reused. As a result, the life of the wafer support can be extended.

The wafer support 30 according to the present embodiment satisfies |Δ2-Δ1| ≤ 1.0 where a thermal expansion coefficient of the base material 14 is represented by Δ1 [1×10⁻⁶/°C] and a thermal expansion coefficient of the protective layer 15, which is a first layer, is represented by Δ2 [1×10⁻⁶/°C]. This allows the base material 14 and the protective layer 15 to be integrally formed by sintering. If the value of |Δ2-Δ1| is large, it is likely that a crack or the like occurs on either of the base material 14 and the protective layer 15 due to thermal stress during firing and good-quality sintered components cannot be obtained. In particular, boron nitride is a material having a low Young's modulus and thus has an effect of reducing thermal stress and reducing occurrence of a crack, it is effectively used as a gradient material for mitigating mismatches in characteristics between layers. In addition, according to the method of sintering integrally, a layer made of a highly thermally conductive material, which cannot be made with conventional machinable ceramics, can be formed on or near a wafer contact surface, which improves thermal uniformity of wafers in a semiconductor manufacturing process. Specifically, while the thermal conductivity achieved with conventional machinable ceramics is only up to about 70 W/m•K, a thermal conductivity of 90 W/m•K or higher can be achieved by providing an aluminum nitride-based ceramic sintered body, that is, the protective layer 15 on the base material 14.

If the difference Δ=|Δ2-Δ1| in thermal expansion coefficient between the base material 14 and the protective layer 15 is larger than 1.0, an intermediate layer having a thermal expansion coefficient Δ3 between the thermal expansion coefficient Δ1 and the thermal expansion coefficient Δ2 (Δ1<Δ3<Δ2 or Δ2<Δ3<Δ1) may be formed between the base material 14 and the protective layer 15. In this case, both of the thermal expansion coefficient differences |Δ1-Δ3| and |Δ2-Δ3| are preferably 1.0×10⁻⁶/°C or smaller.

Note that the machinable ceramic of the base material according to the present embodiment may include 15 to 40 mass% of boron nitride, 0 to 40 mass% of zirconium oxide, 0 to 50 mass% of silicon nitride, 0 to 20 mass% of silicon carbide, and 0 to 75 mass% of aluminum nitride with respect to 100% of a total of ceramic components of boron nitride, zirconium oxide, silicon nitride, silicon carbide, and aluminum nitride. The machinable ceramic may further include 3 to 15 mass% of a sintering aid component with respect to 100 mass% of the total of the ceramic components.

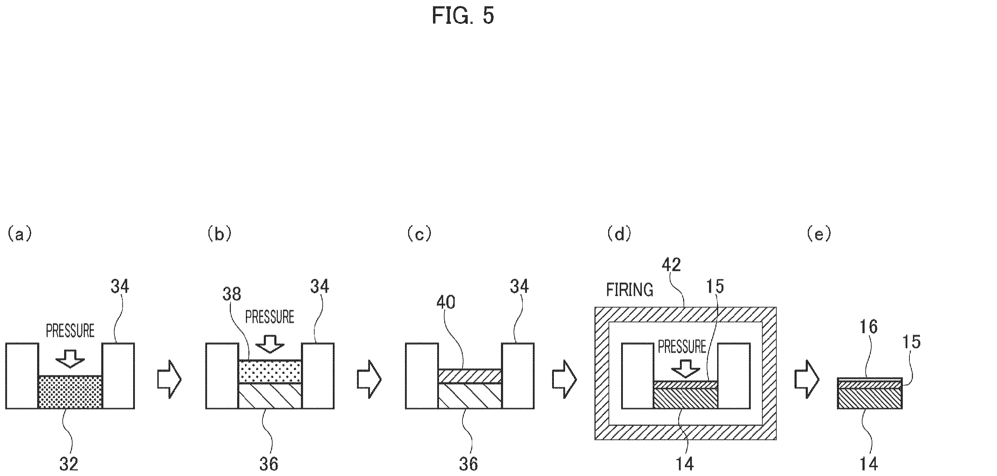

In FIG. 5, (a) to (e) are diagrams illustrating an example of a method for manufacturing the wafer support according to the present embodiment. First, as illustrated in (a) in FIG. 5, powder 32 adjusted to the composition of the base material 14 is loaded into a hot press mold 34 and uniaxially compacted to form a first compacted body 36 ((b) in FIG. 5). Subsequently, powder 38 adjusted to the composition of the protective layer 15 is loaded on the first compacted body 36 and uniaxially compacted to form a second compacted body 40 on the first compacted body 36 ((c) in FIG. 5). The thus obtained two-layered molded body is placed in a firing furnace 42 and subjected to hot press firing ((d) in FIG. 5). The base material 14 and the protective layer 15 are integrally formed in this manner, and the protective layer 16 is further formed on the protective layer 15 by CVD or PVD ((e) in FIG. 5).

Alternatively, after the powder 32 is loaded into the mold 34, the powder 38 may be loaded on the powder 32 in the mold 34, and the powder 32 and the powder 38 may be uniaxially compacted at the same time. In another manufacturing method, a molded body obtained by cold isostatic pressing (CIP) of the powder 38 may be placed on a molded body obtained by CIP of the powder 32, and the molded bodies may be integrally formed by hot press firing.

### [Examples]

Next, the characteristics of wafer supports according to Examples and Comparative Examples will be described. The contents of the ceramic component and the sintering aid component in each of the Examples and Comparative Examples are as shown in Table 1. The film thickness was measured from a sectional photograph taken with a scanning electron microscope.

**[Table 1]**

| | Base material | | | | | | | | First layer (AlN bulk) contents (mass%) | | | | Second layer (Protective film to plasma) | |
|---|---|---|---|---|---|---|---|---|---|---|---|---|---|---|
| | Ceramic components (100 mass%) | | | | | Sintering aid component (+α mass%) | | | AlN | BN | Remaining contents (+α mass%) | | Material | Film thickness |
| | BN | ZrO₂ | Si₃N₄ | SiC | AlN | Y₂O₃ | Al₂O₃ | MgO | | | Y₂O₃ | MgO | | (µm) |
| Example 1 | 25.0 | 0.0 | 0.0 | 0.0 | 75.0 | 3.0 | 0.0 | 0.0 | 100.0 | 0.0 | 0.0 | 0.0 | AlN | 5.0 |
| Example 2 | 30.0 | 0.0 | 0.0 | 0.0 | 70.0 | 6.0 | 0.0 | 4.0 | 93.0 | 7.0 | 4.0 | 0.0 | Y₂O₃ | 20.0 |
| Example 3 | 40.0 | 40.0 | 0.0 | 20.0 | 0.0 | 8.0 | 4.0 | 3.0 | 100.0 | 0.0 | 5.0 | 0.0 | AlN | 1.5 |
| Example 4 | 15.0 | 20.0 | 50.0 | 15.0 | 0.0 | 0.0 | 5.0 | 3.0 | 95.0 | 5.0 | 0.0 | 5.0 | Al₂O₃ | 10.0 |
| Example 5 | 20.0 | 0.0 | 40.0 | 0.0 | 40.0 | 2.0 | 0.0 | 4.0 | 90.0 | 10.0 | 0.0 | 0.0 | MgO | 5.0 |
| Comparative Example 1 | 35.0 | 0.0 | 0.0 | 0.0 | 65.0 | 2.0 | 0.0 | 4.0 | 100.0 | 0.0 | 0.0 | 0.0 | Protective film is absent | |
| Comparative Example 2 | 40.0 | 45.0 | 0.0 | 15.0 | 0.0 | 0.0 | 5.0 | 3.0 | 95.0 | 5.0 | 6.0 | 0.0 | Protective film is absent | |
| Comparative Example 3 | 40.0 | 0.0 | 35.0 | 25.0 | 0.0 | 6.0 | 0.0 | 4.0 | 90.0 | 10.0 | 0.0 | 3.0 | Protective film is absent | |

### (Cross-sectional structure)

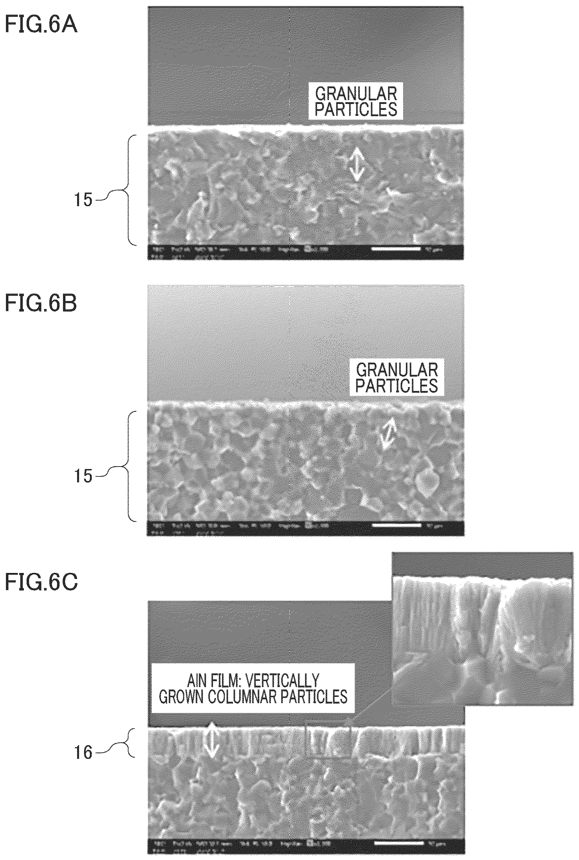

FIG. 6A shows a photograph of a section of a protective layer of an aluminum nitride sintered body according to Example 1 taken with a scanning electron microscope (SEM), FIG. 6B shows a photograph of a section of a protective layer of an aluminum nitride sintered body according to Example 3 taken with the scanning electron microscope, and FIG. 6C shows a photograph of a section of the aluminum nitride film according to the reference example taken with a scanning electron microscope.

The protective layers 15 of the aluminum nitride sintered bodies shown in FIGS. 6A and 6B have a structure packed with particles having a particle size of about 1 to 5 µm. In contrast, the aluminum nitride film shown in FIG. 6C is formed by sputtering and having a structure packed with columnar particles having a particle size smaller than 1 µm and being in alignment. This shows that the sintered body and the film are clearly different in structure from each other. In addition, use of the aluminum nitride sintered body as a gradient material allows formation of the protective layer 15 (corrosion-resistant layer) having such a thickness that is difficult to achieve by the method of forming an aluminum nitride film. As a result, the durability (life) of the wafer support according to the present embodiment is increased.

Table 2 shows the sample surface characteristics and the results of plasma exposure test of the wafer support according to each of Examples 1 to 5 and Comparative Examples 1 to 3. The presence of cracks was checked visually or with a stereoscopic microscope (magnification: ×20).

**[Table 2]**

| | CTE of base material | CTE of first layer | CTE difference | Crack | Sample surface characteristics | | Plasma exposure test | |
|---|---|---|---|---|---|---|---|---|
| | Δ1 | Δ2 | Δ2-Δ1 | ○: No crack | Surface roughness Ra | Vickers hardness | Corrosion amount | Surface roughness Ra |
| | | | | ×: Crack present | (µm) | (GPa) | (µm) | (µm) |
| Example 1 | 3.84 | 4.44 | 0.60 | ○ | 0.08 | 11.2 | 0.0 | 0.08 |
| Example 2 | 3.62 | 4.31 | 0.69 | ○ | 0.13 | 5.6 | 0.0 | 0.12 |
| Example 3 | 3.66 | 4.12 | 0.46 | ○ | 0.08 | 10.6 | 0.0 | 0.08 |
| Example 4 | 4.40 | 4.60 | 0.20 | ○ | 0.10 | 10.4 | 0.0 | 0.11 |
| Example 5 | 2.99 | 3.93 | 0.94 | ○ | 0.05 | 4.0 | 0.0 | 0.06 |
| Comparative Example 1 | 3.04 | 4.44 | 1.40 | × | Not conducted due to occurrence of crack | | | |
| Comparative Example 2 | 3.34 | 4.52 | 1.18 | × | | | | |
| Comparative Example 3 | 2.15 | 3.93 | 1.78 | × | | | | |

### (Sample Surface Characteristics)

In FIG. 7, (a) shows a photograph of a surface of the protective layer of the aluminum nitride sintered body according to Example 1 taken with a scanning electron microscope (SEM), (b) shows a photograph of a surface of the protective layer of the aluminum nitride sintered body according to Example 3 taken with the scanning electron microscope, (c) shows a photograph of a surface of the aluminum nitride film according to the reference example taken with the scanning electron microscope, (d) shows an image obtained by converting the photograph of (a) by image analysis software, (e) shows an image obtained by converting the photograph of (b) by the image analysis software, and (f) shows an image obtained by converting the photograph of (c) by the image analysis software.

Note that the SEM photographs shown in (a) to (c) in FIG. 7 were taken at a magnification of x1000. The image analysis was conducted by extracting depressions by using image analysis software (WIN ROOF) and calculating the area ratio of the depressions. In order to extract the area ratio of clear depressions, depressions of 1 µm² or smaller are excluded from calculation by the image analysis software.

The surfaces of the aluminum nitride sintered bodies shown in (a) and (b) in FIG. 7 are different in the shapes, the sizes, and the area ratios of depressions and projections from the surface of the aluminum nitride film shown in (c) in FIG. 7. For example, the depressions (pores) of the surfaces of the aluminum nitride sintered bodies have shapes with sharp edges, while the depressions (pores) of the surface of the aluminum nitride film have shapes without sharp edges. In addition, the area ratio (0.6%) of the depressions of the surface of the aluminum nitride film is smaller than those of the surfaces of the aluminum nitride sintered bodies. Note that many pores and sharp edges increase the surface area and thus increase the area exposed to corrosive gas, which is disadvantageous in terms of corrosion resistance. Therefore, a smaller area ratio is preferable.

As the state of the sample surface, the arithmetic mean roughness Ra specified in JIS B 0601 was measured. In each of Examples 1 to 5, the measurement was performed on the surface of the film corresponding to the protective layer 16.

### (Plasma Exposure Test)

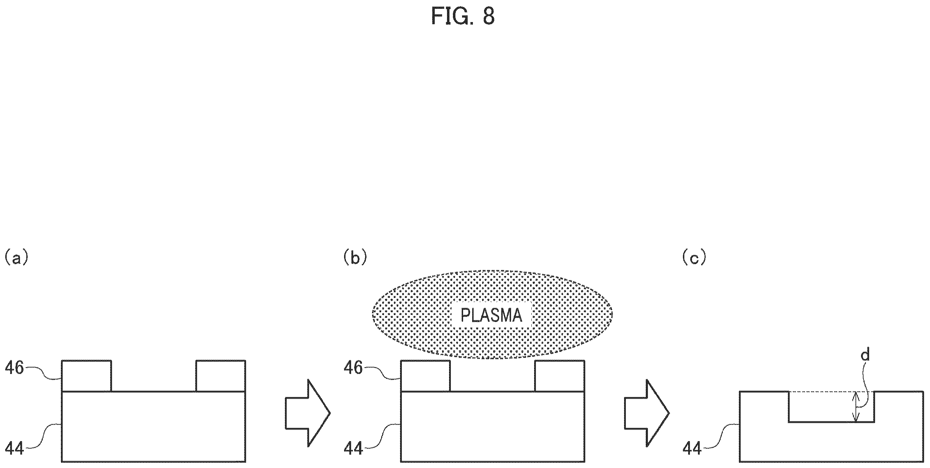

In FIG. 8, (a) to (c) are schematic diagrams for explaining a plasma exposure test. The plasma generator used in the test is RIE-10N manufactured by Samco Inc. The plasma output is 100 W, and the kind of the gas is a mixture of 40 sccm of CF₄ and 10 sccm of O₂. The pressure is 40 Pa, and the treatment time is 240 minutes (30 minutes × 8 times). As illustrated in (a) in FIG. 8, a mask 46 such as a Kapton tape is attached to a part of a sample 44 to be tested imitating a wafer support, and as illustrated in (b) in FIG. 8, plasma treatment is performed. The mask 46 is removed after a predetermined treatment time, and the level difference d between a place not covered with the mask 46 and a place covered with the mask 46 is measured as a corrosion amount (see (c) in FIG. 8). As shown in Table 2, in the wafer supports according to Examples 1 to 5, the level difference d was 0 µm, and corrosion was not confirmed.

### (Vickers Hardness)

The corrosion resistance to plasma may be affected by physical etching in addition to etching by a chemical reaction described above. The corrosion resistance to a chemical reaction is improved, for example, by using a material including a substance that is less likely to sublimate even when reacted with plasma in which a fluorine-based (CF₄) gas is used (such as aluminum or yttrium) as the protective layer. In addition, a protective layer having a high hardness so as to be resistant to physical impact is expected to have further high corrosion resistance to plasma.

Therefore, the inventors of the present application focused on the film hardness of the protective layer. The film hardness was obtained by measuring the nanoindentation hardness H_IT by a nanoindentation method and converting the nanoindentation hardness H_IT into the Vickers hardness (GPa). For example, the wafer supports according to Examples 1, 3, and 4 have a Vickers hardness of 10 GPa or more, and are expected to have further high corrosion resistance to plasma with consideration of the results of the corrosion amount by the plasma exposure test.

While the present invention has been described above with reference to the embodiments and examples, the present invention is not limited to the embodiments, and any combination or substitution of components in the embodiments as appropriate is included in the present invention. In addition, modifications such as combinations, changes in the order of processes, and various design changes to the embodiments may be made on the basis of knowledge of a person skilled in the art, and such modified embodiments may be within the scope of the present invention.

### Industrial Applicability

The present invention can be used for an electrostatic chuck.

## Claims

1. A wafer support comprising: a base material made of a machinable ceramic including boron nitride; a first layer covering a surface of the base material; and a conductive member placed at least partially inside the base material,
the first layer being made of an aluminum nitride-based ceramic sintered body,
a proportion of boron nitride included in the base material being higher than a proportion of boron nitride included in the first layer.

2. The wafer support according to claim 1, wherein the first layer has a thickness of 0.3 to 3.0 mm.

3. The wafer support according to claim 1 or 2, wherein the first layer includes 90 to 100 mass% of aluminum nitride and 0 to 10 mass% of boron nitride.

4. The wafer support according to claim 1 or 2, further comprising:
a second layer covering the first layer,
wherein the second layer includes at least one material selected from the group consisting of aluminum nitride, aluminum oxide, yttrium oxide, and magnesium oxide, and has a thickness of 1.0 to 20 µm.

5. The wafer support according to claim 1 or 2, wherein |Δ2-Δ1| ≤ 1.0 is satisfied where a thermal expansion coefficient of the base material is represented by Δ1 [1×10⁻⁶/°C] and a thermal expansion coefficient of the first layer is represented by Δ2 [1×10⁻⁶/°C].

6. The wafer support according to claim 1 or 2,
wherein the machinable ceramic includes 15 to 40 mass% of boron nitride, 0 to 40 mass% of zirconium oxide, 0 to 55 mass% of silicon nitride, 0 to 20 mass% of silicon carbide, and 0 to 75 mass% of aluminum nitride with respect to 100% of a total of ceramic components of boron nitride, zirconium oxide, silicon nitride, silicon carbide, and aluminum nitride, and
wherein the machinable ceramic further includes 3 to 15 mass% of a sintering aid component with respect to 100 mass% of the total of the ceramic components.

7. The wafer support according to claim 1 or 2, the conductive member includes a metal material selected from the group consisting of molybdenum, tungsten, tantalum, and alloys containing molybdenum, tungsten, or tantalum.
